# EUROPEAN PATENT APPLICATION

(11) **EP 4 852 264 A1**
(43) Date of publication of application: **09.12.2026**
(21) Application number: 25181385.3
(22) Date of filing: 06.06.2025
(51) Int. Cl.: H02J 3/00, H02J 9/06, H02J 13/00, G01R 19/00

(54) **METHOD FOR CONTROLLING AN IMPEDANCE ISOLATED SINGLE CONVERSION TOPOLOGY UNINTERRUPTIBLE POWER SUPPLY SYSTEM AND AN IMPEDANCE ISOLATED SINGLE CONVERSION TOPOLOGY UNINTERRUPTIBLE POWER SUPPLY SYSTEM AND COMPUTER PROGRAM PRODUCT**

(71) Applicant: ABB SCHWEIZ AG, 5400 Baden (CH)
(72) Inventor: NGO, Tung, 4112 Napier (NZ)
(74) Representative: Zimmermann & Partner Patentanwälte mbB

(57) **Abstract**

A method 300 for controlling an impedance isolated single conversion topology uninterruptible power supply system comprising current and voltage sensors, a power converter, a coupling transformer, a reactor, and having an impedance isolated single converter topology, the method comprising:
- measuring 302 a plurality of voltages and/or currents using the current and voltage sensors of the uninterruptible power supply system to obtain a plurality of measured parameters of the uninterruptible power supply;
- computing 304 one or more error signals, wherein each error signal is based on a distance between a measured parameter of the uninterruptible power supply and a corresponding estimated value of the measured parameter; wherein the estimated value of the measured parameter is computed based on one or more other measured parameters in the plurality of measured parameters and/or based on a model of the uninterruptible power supply;
- filtering 306 each error signal to obtain one or more filtered error signals;
- inputting 308 each of the one or more filtered error signals to a comparator with hysteresis to obtain one or more Boolean error signals;
- applying 310 a fault identification logic to the one or more Boolean error signals to obtain an indication of a sensor fault related to a sensor of the uninterruptible power supply system or the indication of an absence of sensor faults;
- controlling 312 the uninterruptible power supply system based on the indication of the sensor fault or on the indication of the absence of sensor faults.

## Description

### FIELD

The present disclosure relates to a method for controlling an impedance isolated single conversion topology uninterruptible power supply system and to an impedance isolated single conversion topology uninterruptible power supply system, the method in particular comprising applying a fault identification logic to one or more Boolean error signals to obtain an indication of a sensor fault related to a sensor of the uninterruptible power supply system; the system in particular comprising a system controller configured to apply a fault identification logic to one or more Boolean error signals to obtain an indication of a sensor fault related to a sensor of the uninterruptible power supply system or the indication of an absence of sensor faults.

### BACKGROUND

An uninterruptible power supply (UPS) system provides electric power to a load, in particular when the power delivered by an electric line is absent or insufficient.

An UPS system may have an Impedance Isolated Single Conversion (ZISC) topology.

An UPS typically includes an energy storage system connected to a power conversion system. The energy storage system is charged using electric energy from an electric grid when the electric grid is able to provide enough power. In addition, the energy storage system may provide electric energy to a load, in particular when the electric gird is not able to supply enough power towards the load.

In particular, the energy storage system may be charged when the electric grid provides the required power and in case of an outage, the energy stored in the energy storage system is supplied towards the load.

A UPS system typically operates in a power conditioning mode (PCM) and/or in an independent mode (IM). To provide the correct amount of power and to operate with high performance, a plurality of sensors is present in an UPS, in particular sensor configured to measure input and output voltage and/or current and/or sensors configured to measure the voltage and/or current provided by a converter of the UPS. The sensors in an UPS may experience faults. Sensor faults in an UPS may occur for a plurality of reasons, such as faults in electrical connections, faults in the circuitry of the sensor, environmental disturbances, or physical damage or some or all of the subsystems of the sensor. A sensor experiencing a fault may provide unreliable information, thus causing the overall UPS system to become unreliable.

To detect sensor faults according to known solutions, redundant sensors are used. But redundant sensors increase the complexity of the UPS system.

It is therefore beneficial to provide an improved detection of sensor faults in an UPS and in particular in an UPS with ZISC topology while avoiding redundant sensors.

### SUMMARY

The invention is defined by the independent claims. Dependent claims define further embodiments of the invention.

According to an aspect, a method is provided for controlling an impedance isolated single conversion topology uninterruptible power supply system comprising current and voltage sensors, a power converter, a coupling transformer, a reactor, and having an impedance isolated single converter topology, the method comprising:
- measuring a plurality of voltages and/or currents using the current and voltage sensors of the uninterruptible power supply system to obtain a plurality of measured parameters of the uninterruptible power supply;
- computing one or more error signals, wherein each error signal is based on a distance between a measured parameter of the uninterruptible power supply and a corresponding estimated value of the measured parameter; wherein the estimated value of the measured parameter is computed based on one or more other measured parameters in the plurality of measured parameters and/or based on a model of the uninterruptible power supply;
- filtering each error signal to obtain one or more filtered error signals;
- inputting each of the one or more filtered error signals to a comparator with hysteresis to obtain one or more Boolean error signals;
- applying a fault identification logic to the one or more Boolean error signals to obtain an indication of a sensor fault related to a sensor of the uninterruptible power supply system or the indication of an absence of sensor faults;
- controlling the uninterruptible power supply system based on the indication of the sensor fault or on the indication of the absence of sensor faults.

According to a further aspect, an impedance isolated single conversion topology uninterruptible power supply system is provided comprising current and voltage sensors, a power converter, a coupling transformer, a reactor, and a system controller and having an impedance isolated single conversion topology, wherein:
- the system controller is configured to obtain a plurality of measured parameters of the uninterruptible power supply system based on measured voltages and/or currents obtained with the current and voltage sensors of the uninterruptible power supply system;
- the system controller is configured to compute one or more error signals, wherein each error signal is based on a distance between a measured parameter of the uninterruptible power supply and a corresponding estimated value of the measured parameter; wherein the estimated value of the measured parameter is computed based on one or more other measured parameters in the plurality of measured parameters and/or based on a model of the uninterruptible power supply;
- the system controller is configured to filter each error signal to obtain one or more filtered error signals;
- the system controller is configured to implement a comparator with hysteresis to obtain one or more Boolean error signals such that each of the one or more filtered error signals is inputted to the comparator with hysteresis to obtain the one or more Boolean error signals;
- the system controller is configured to apply a fault identification logic to the one or more Boolean error signals to obtain an indication of a sensor fault related to a sensor of the uninterruptible power supply system or the indication of an absence of sensor faults;
- the system controller is configured to control the uninterruptible power supply based on the indication of the sensor fault or on the indication of the absence of sensor faults.

According to a further aspect, a computer program product is provided comprising instruction which, when executed by a system controller of an impedance isolated single conversion topology uninterruptible power supply system according to embodiments of the present disclosure, causes the system controller of the impedance isolated single conversion topology uninterruptible power supply system to carry out the methods according to embodiments of the present disclosure.

### BRIEF DESCRIPTION OF THE FIGURES

The accompanying drawings relate to embodiments of the disclosure and are described in the following:
FIG. 1 shows an Impedance Isolated Single Conversion topology uninterruptible power supply system according to embodiments of the present disclosure.
FIG. 2 shows a fault identification logic according to embodiments of the present disclosure.
FIG. 3 shows a method for controlling an impedance isolated single conversion topology uninterruptible power supply system according to embodiments of the present disclosure.

### DETAILLED DESCRIPTION

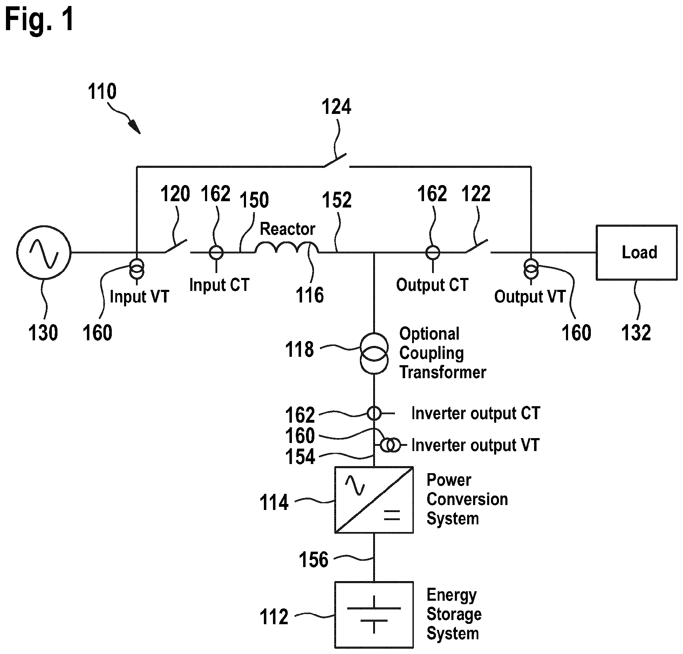

FIG. 1 shows an Impedance Isolated Single Conversion (ZISC) topology uninterruptible power supply (UPS) system 110 according to embodiments of the present disclosure. The ZISC UPS system 110 includes an energy storage system 112, a power conversion system 114, and a reactor 116. The ZISC UPS system 110 may further include a coupling transformer 118.

The Impedance Isolated Single Conversion (ZISC) topology uninterruptible power supply (UPS) system 110 further includes an input switch 120, an output switch 122, and a bypass switch 124.

The Impedance Isolated Single Conversion (ZISC) topology uninterruptible power supply (UPS) system 110 is coupled to an electric grid 130 and to an electric load 132.

The electric grid and the electric load are not part of the UPS system as such, but are described and illustrated to explain the function of the UPS system according to embodiments of the present disclosure.

The reactor 116 has a grid side terminal 150 and a load side terminal 152.

The power conversion system 114 has an AC terminal 154 and a DC terminal 156.

The load side terminal of the reactor 152 may be coupled to the AC terminal of the power conversion system 154, in particular via the coupling transformer 118.

The DC terminal 156 of the power conversion system 114 is coupled to the energy storage system 112.

The electric grid 130 may be coupled to the grid side terminal 150 of the reactor 116 when the input switch 120 is closed. The load 132 may be coupled to the load side terminal 152 of the reactor 116 when the output switch 122 is closed. When the bypass switch 124 is closed the electric grid 130 may be coupled directly to the electric load 132. For example, when both the input switch 120 and the output switch 122 are opened and the bypass switch 124 is closed, the ZISC based UPS system 110 may be effectively bypassed.

Alternatively, when both the input switch 120 and the output switch 122 are closed and the bypass switch 124 is open, the ZISC based UPS system 110 may be effectively used to condition power in a power conditioning mode (PCM).

When the input switch 120 is open and the output switch 122 is closed and the bypass switch 124 is open, the ZISC based UPS system 110 may be effectively used to deliver power to the load 132 operating in an independent mode (IM), for example in case of a power outage in the grid 130.

In power condition mode, the load power is drawn from the grid through the isolation reactance. The load voltage is regulated by the power conversion system by supplying reactive current into the circuit. The load power and any system losses are sourced from the grid. The power conversion system draws just sufficient average power to compensate for the very small losses of the converter system and to recharge the batteries.

If the grid voltage deviates by a large degree in all phases, it becomes untenable to draw all the load power from the grid, so the power conversion system supplies the shortfall. In extreme cases where the grid voltage drops to a very low level (deep sag), or the grid circuit is open (interruption), the UPS opens it input switch and transfers the load to the energy storage, operating in independent mode. The energy storage allows ride-through time for either the grid voltage to be restored, or for the time necessary for an alternative energy source to be activated, such as a diesel generator for example.

In the independent mode therefore, the ZISC based UPS system 110 is disconnected from the grid 130 and operates in island mode to supply power to the load 132.

For a proper functioning of the ZISC based UPS system 110, in particular in the power conditioning mode, a plurality of sensors, e.g. voltage sensors and current sensors are typically useful.

In particular, it is typically necessary to measure the voltage and current provided by the grid 130, the voltage and current transferred to the load 132 and the voltage and current provided by the power conversion system 114, e.g. at the AC terminal of the power conversion system 154.

A plurality of voltage 160 and current 162 sensors are therefore present to measure in particular the voltage and current provided by the grid 130, the voltage and current transferred to the load 132 and the voltage and current provided by the power conversion system 114, e.g. at the AC terminal of the power conversion system 154.

In particular the voltage sensors 160 and/or the current sensors 162 are typically useful to control the power delivery towards the load and to implement a proper compensation of disturbances, e.g. to counteract disturbances affecting the grid voltage and/or grid current in order to provide an undisturbed voltage and current to the load 132.

If a voltage and/or current sensor experiences a fault, it may provide erroneous measurement results that may negatively affect the ability of the ZISC based UPS system 110 to compensate disturbances of the grid when operating in power conditioning mode. However, also when operating in independent mode, it is necessary to detect sensor faults in order to ensure a proper functioning of the ZISC based UPS system, in particular such that the power conversion system can provide the proper power towards the load.

Redundant sensors may be used to detect sensor faults, i.e. multiple sensors measure the same quantity and in case of disagreement a fault is detected. However, redundant sensors increase the complexity and cost.

Embodiments of the present disclosure provides methods and systems for sensor fault detection in a ZISC based UPS system without the need of redundant sensors.

According to embodiments of the present disclosure, sensors produce measured values. Based on measured values provided by some sensor(s) it is possible to estimate or compute estimated value(s) for the measurement(s) that other sensor(s) are expected to provide. Error signal(s) may then be computed based on a difference or distance between the estimated values(s) and the value(s) measured by the other sensor(s). The error signal(s) may be filtered and fed into comparator(s), e.g. comparator(s) with hysteresis. A fault identification logic may then determine if a sensor fault is (likely) present.

The following definition is introduced under the assumption that the input switch 120 and the output switch 122 are both closed and the bypass switch 124 is open, i.e. for the ZISC based UPS system functioning in a power conditioning mode (PCM): ${i}_{in} = Re \left\{{I}_{in}{e}^{j ω t}\right\}$ wherein *iᵢₙ* is the input current provided by the grid 130 to the reactor 116, i.e. the current flowing through the reactor 116 from the grid side terminal 150 of the reactor 116 to the load side terminal 152 of the reactor 116.

*Iᵢₙ* is a phasor describing the input current: ${I}_{in} = {I}_{in , mag} {e}^{{jI}_{in , phase}}$ based on the magnitude *I_{in,mag}* and the phase *I_{in,phase}* of the input current *iᵢₙ*.

Analogous phasors are considered for other currents and voltages.

In the following, instantaneous currents and voltages are identified with the corresponding description with phasors and vice versa.

Observing magnitude and phase of a signal it is therefore possible to consider the corresponding phasor and vice versa.

By the complex Ohm's law, it follows: ${I}_{in} = \frac{{U}_{in} - {U}_{out}}{{Z}_{r}}$ wherein *Uᵢₙ* is the complex input voltage provided by the grid, *Uₒᵤₜ* is the complex output voltage received by the load and *Zᵣ* is the reactor impedance.

Alternatively, in particular if the voltage and current signals are not sinusoidal and/or in the presence of transients and disturbance the input current may be obtained in the time domain as ${i}_{in} \left(t\right) = {i}_{in} \left({t}_{0}\right) + \frac{1}{L} {\int }_{{t}_{0}}^{t} \left({u}_{in}\left(τ\right)-{u}_{out}\left(τ\right)\right) dτ 3 T$ wherein currents and voltages are considered in the time domain and with L being the inductance of the reactor and *iᵢₙ*(*t*₀) being the input current at time *t*₀ and assuming that the resistance of the reactor/coil is negligible. Equation (3T) in the time domain corresponds to equation (3) expressed with phasors for the special case that *Zᵣ = jωL*, i.e. for the case of the resistance R of the reactor/coil equal to zero.

Another alternative formulation may be in terms of Laplace transforms and/or solving analytically or numerically the differential equation describing the reactor. Analogously for the other components of the UPS.

For example, therefore, using (3T) or (3) in combination with (1) and/or any equivalent or alternative formulation with obtainable analytic or numeric solutions, it is therefore possible to estimate/compute the input current knowing the input and output voltages, e.g. obtaining the phasors of the input and output voltage, then obtaining the phasor of the input current using the complex Ohm's law and finally obtaining the input current. Analogously for the other components of the UPS.

For simplicity equations with phasors are described in full detail, but alternatively corresponding equations in the time domain and/or in the Laplace domain may be considered instead. For example differential equations may be considered and solution may be obtained analytically or numerically.

To remark that the input voltage phasor is estimated based on the measured input and output voltage phasors: ${I}_{in , est} \left({U}_{in , mes}, {U}_{out , mes}\right) = \frac{{U}_{in , mes} - {U}_{out , mes}}{{Z}_{r}}$ wherein *"mes"* denotes a quantity computed based on measured values and *"est"* a quantity that is estimated/computed not relying on a direct measurement of the considered quantity.

More in detail, the estimated quantities estimate a quantity under observation (voltage or current) based on other quantities, e.g. other voltages and/or currents that are measured by other sensors that are assumed to work properly. Comparing the estimated quantity under observation with a corresponding directly measured quantity, it is possible to detect a fault of the sensor that measures said corresponding measured quantity in the case that estimated quantity and corresponding measured quantity differ, at least under the assumption that only said sensor is faulty while the different sensors on which the estimated quantity rely still work properly.

Measured quantities are indicated with the subscript *"mes"* and estimated or computed quantities with the subscript *"est".*

Instantaneous currents are indicated with lowercase letters and corresponding phasors with uppercase letters, if not otherwise stated but the two descriptions are considered equivalent.

Therefore, for example *u_{in,mes}* is the instantaneous measured input voltage, *u_{in,est}* is the instantaneous estimated input voltage, and *U_{in,mes}, U_{in,est}* are the corresponding phasors. Similarly, for other quantities, if not otherwise stated.

It is therefore for example possible to estimate the input current *I_{in,est}* based on the measured input voltage *U_{in,mes}* and the measured output voltage *U_{out,mes}.*

*I_{in,est}* is an estimated value of the input current (phasor).

It is also possible to know the output voltage (phasor) knowing the voltage at the AC terminal of the power conversion system 154 knowing the characteristics of the coupling transformer.

For example, assuming that the coupling transformer is an ideal transformer: ${U}_{out , est} = \frac{{N}_{out}}{{N}_{converterAC}} {U}_{converterAC , mes}$ wherein *U_{converterAC,mes}* is the measured voltage (phasor) at the AC terminal of the power conversion system 154 and *Nₒᵤₜ* is the number of turns of the winding of the coupling transformers at the grid side and *N_{converterAC}* is the number of turns of the winding of the coupling transformer at the AC terminal 154 side coupled to the power conversion system.

Accordingly, it is possible to estimate the output voltage *U_{out,est}* in function of the measured voltage *U_{converterAC,mes}* at the AC terminal of the converter: ${U}_{out , est} \left({U}_{converterAC , mes}\right) = \frac{{N}_{out}}{{N}_{converterAC}} {U}_{converterAC , mes}$

For simplicity *U_{out,est}* is also denoted as a converted value of the measured converter output voltage *U_{converterAC,mes}* at the primary side of the coupling transformer, i.e. at the AC terminal 154.

If now the output voltage sensor, i.e. the sensor that measures the voltage phasor *U_{out,mes}* at the load side experiences a fault, then the ${U}_{out , mes} \neq {U}_{out , est} \left({U}_{converterAC , mes}\right)$ in the hypothesis that the voltage sensor that measures the voltage at the AC terminal of the power conversion system 154 still works properly.

But in addition, also ${I}_{in , mes} \neq {I}_{in , est} \left({U}_{in , mes}, {U}_{out , mes}\right)$ because the expression on the right-hand side will no more return a correct value for *I_{in,est}.*

The power converter 114 typically comprises one or more modules connected in parallel, the *i - th* module providing a current *I_{moduleᵢ}.*

The overall current *I_{converterAC}* is therefore the sum of the current provided by each module ${I}_{converterAC} = {\sum }_{i = 1}^{n} {I}_{{module}_{i}}$ where N is the total number of modules providing current in parallel within the power converter 114.

Knowing/measuring the currents actually provided by each module it is possible to estimate/compute the current at the AC terminal of the power conversion system: ${I}_{converterAC , est} \left({I}_{{module}_{1} , mes , … , {I}_{\left\{\left.{module}_{n}, mes\right)\right.}}\right) = {\sum }_{i = 1}^{n} {I}_{{moudule}_{i} , mes}$

The current *I_{converterAC,est}* and the current(s) *I_{module_{i,mes}}* are considered positive when flowing outwards from the AC terminal of the power conversion system 154.

By Kirchhoff s current law, the output current is ${I}_{out} = {I}_{in} + {I}_{converterAC}$ wherein the output current *Iₒᵤₜ* is considered positive when flowing into the load 132.

Accordingly: ${I}_{out , est} \left({I}_{in , mes}, {I}_{converterAC , mes}\right) = {I}_{in , mes} + {I}_{converterAC , mes}$

When the output voltage sensor experiences a fault (in particular when assuming that other sensors still working properly), i.e. when the sensor that measures *U_{out,mes}* is malfunctioning, i.e. when *U_{out,mes}* is erroneous, then a difference between the measured input current *Iiₙ,ₘₑₛ* and the estimated input current *I_{in,est}*(*U_{in,Mes},U_{out,mes}*)according to (4) is observed and also a difference between the measured output voltage *U_{out,mes}* and the converted value *U_{out,est}*(*U_{converterAC,mes}*) according to (5) of the measured converter output voltage at the primary side of the coupling transformer is observed. This is a consequence of *I_{in,est}*(*U_{in,mes},U_{out,mes}*) depending on the erroneous value of *U_{out,mes}*.

When the converter output current sensor experiences a fault (in particular when assuming that other sensors still work properly), i.e. when the sensor that measures *I_{converterAC,mes}* experiences a fault, i.e. when *I_{converterAC,mes}* is erroneous, then a difference between the measured converter output current *I_{converterAC,mes}* (considered positive when flowing outwards from the AC terminal of the power conversion system) and the estimated converter output current *I_{converterAC,est}* according to (7) is observed. In addition, the estimated output current *I_{out,est}*(*I_{in,mes},I_{converterACmes}*) according to (8) will also differ from the measured output current *I_{out,mes}.* This is a consequence of *I_{out,est}*(*I_{in,mes}*,*I_{converterAC,mes}*) depending on the erroneous value of *I_{converterAC,mes}*.

When the converter output voltage sensor experiences a fault (in particular when assuming that other sensors still work properly), i.e. when the sensor that measures *U_{converterAC,mes}* experiences a fault, i.e. when *U_{converterAC,mes}* is erroneous, then the estimated/converted value *U_{out,est}*(*U_{converterAC,mes}*) according to (5) in function of the measured converter output voltage *U_{converterAC,mes}* at the primary side of the coupling transformer will differ from the measured output voltage magnitude *U_{out,mes}.* I.e. therefore *U_{out,mes}* ≠ *U_{out,est}* (*U_{converterAC,mes}*)*.* Conversely, in this case, the estimated value of the input current *I_{in,est}* (*U_{in,mes},U_{out,mes}*) according to (4) will still depend on correctly measured quantities and will therefore NOT differ from *I_{in,mes},* i.e. the estimated value of the input current will NOT differ from the measured input current.

When the input current sensor experiences a fault (in particular when assuming that other sensors still work properly), i.e. when the sensor that measures *I_{in,mes}* experiences a fault, i.e. when *I_{in,mes}* is erroneous, then measured input current magnitude *I_{in,mes}* differs from the estimated input current *I_{in,est}*(*U_{in,mes},U_{out,mes}*) according to (4).

The estimated value of the output voltage *U_{out,est}*(*U_{converterAc,mes}*) according to (5), i.e. the estimated/converted voltage at the primary side of the coupling transformer, will NOT differ from the measured output voltage *U_{out,mes}* because *U_{converterAC,mes}* will still be correct.

The measured output current magnitude *I_{out,mes}* conversely will differ from the estimated output current magnitude *I_{out,est}*(*I_{in,mes},I_{converterAc,mes}*) according to (8) that depends on the erroneous *I_{in,mes}.*

The measured converter output current *I_{converterAC,mes}* will also not differ from *I_{converterAC,est}* according to (7) that does not depend on the erroneous value *I_{in,mes}.*

When the input voltage sensor experiences a fault (in particular when assuming that other sensors still work properly), i.e. when the sensor that measures *U_{in,mes}* experiences fault, i.e. when *U_{in,mes}* is erroneous, then the estimated value of the input current *I_{in,est}* (*U_{in,mes},U_{out,mes}*) according to (4) will differ from the measured input current *I_{in,mes}.*

Conversely, the measured output voltage *U_{out,mes}* will NOT differ from *U_{out,est}* (*U_{converterAC,mes}*) according to (5), i.e. the measured output voltage will not differ from the converted value of the measured converter output voltage at the primary side of the coupling transformer.

Analogously the estimated output current *I_{out,est}*(*I_{in,mes},I_{converterAc,mes}*) will not differ from the measured output current *I_{out,mes}* not depending on the erroneous *U_{in,mes}*.

When the output current sensor experiences a fault (in particular when assuming that other sensors still work properly), i.e. when the sensor that measures *I_{out,mes}* experiences a fault, i.e. when *I_{out,mes}* is erroneous, then the measured output current *I*_{*out,me*s}differs from *I_{out,est}* (*I_{in,mes},I_{converterAC,mes}*) according to (8).

The estimated converter output current ${I}_{converterAC , est} \left({I}_{{module}_{1} , mes},…,{I}_{\left\{\left.{module}_{n}, mes\right)\right.}\right)$ does NOT differ from the measured converter output current *I_{converterAC,mes}*.

Analogously, the estimated input current *I_{in,est}*(*U_{in,mes}*,*U_{out,mes}*)that does not depend on *I_{out,mes}* does accordingly not differ from the measured input current *I_{in,mes}*.

For completeness following error signals are introduced: ${E}_{1} = \left|{I}_{in , mes}-{I}_{in , est}\left({U}_{in , mes}, {U}_{out , mes}\right)\right| = \left|{I}_{in , mes}-\frac{{U}_{in , mes} - {U}_{out , mes}}{{Z}_{r}}\right|$ $\begin{matrix}{E}_{2} = \left|{U}_{out , mes}-{U}_{out , est}\left({U}_{converterAC , mes}\right)\right| \\ = \left|{U}_{out , mes}-\frac{{N}_{out}}{{N}_{converterAC}}{U}_{converterAC , mes}\right|\end{matrix}$ $\begin{matrix}{E}_{3} = \left|{I}_{out , mes}-{I}_{out , est}\left({I}_{in , mes}, {I}_{converterAC , mes}\right)\right| \\ = \left|{I}_{out , mes}-\left({I}_{in , mes}+{I}_{converterAC , mes}\right)\right|\end{matrix}$ $\begin{matrix}{E}_{4} = \left|{I}_{converterAC , mes}-{I}_{converterAC , est}\left({I}_{{module}_{1} , mes},…,{I}_{\left\{\left.{module}_{n}, mes\right)\right.}\right)\right| \\ = \left|{I}_{converterAC , mes}-{\sum }_{i = 1}^{n} {I}_{{moudule}_{i} , mes}\right|\end{matrix}$

Based on the previous discussion it is possible to identify a sensor fault based on identifying which error signals *E*₁,*E*₂,*E*₃,*E*₄are (significantly) different from zero, wherein always at most two error signals are significantly different from zero at the same time (for any discussed fault).

For all the discussed cases, no more than any two signals in *E*₁*,E*₂*,E*₃*,E*₄ are (significantly) different from zero. Checking therefore that no more than any two error signals among *E*₁,*E*₂ ,*E*₃,*E*₄ are (significantly) different from zero is therefore beneficial to prevent a false positive detection of sensor faults.

For a more convenient fault identification in practice, the error signals may be further filtered and fed into a comparator with hysteresis to obtain from *E*₁,*E*₂*,E*₃*,E*₄ respective binary error flags or Boolean error signals *e*₁,*e*₂*,e*₃*,e*₄*.* A fault identification logic that implements the discussed functions and receives as input the Boolean error signals *e*₁*,e*₂*,e*₃*,e*₄ instead of *E*₁,*E*₂,*E*₃*,E*₄.

The binary error flags or Boolean error signals *e*₁*,e*₂*,e*₃*,e*₄ therefore conveniently indicate if a significant magnitude of the corresponding error signals *E*₁,*E*₂*,E*₃*,E*₄ is observed or not (respectively when high or low).

For a more convenient and clear discussion, *e*₁*,e*₂*,e*₃*,e*₄ are called Boolean error signals.

In particular the Boolean error signal, *eᵢ* is high if an only if the corresponding error signal *Eᵢ* is (significantly) different from zero, in particular if and only if the signal obtained filtering *Eᵢ* and/or using a comparator with hysteresis differs from zero, for i = 1,2,3,4.

The Boolean error signals therefore indicate error values. The Boolean error signals may be still be called error signals in the present disclosure when it is clear from the context that a Boolean value is considered instead of a real or complex value.

When the context clarifies that a Boolean signal is considered, then *e*₁*,e*₂*,e*₃*,e*₄ are called error signal instead of Boolean error signals.

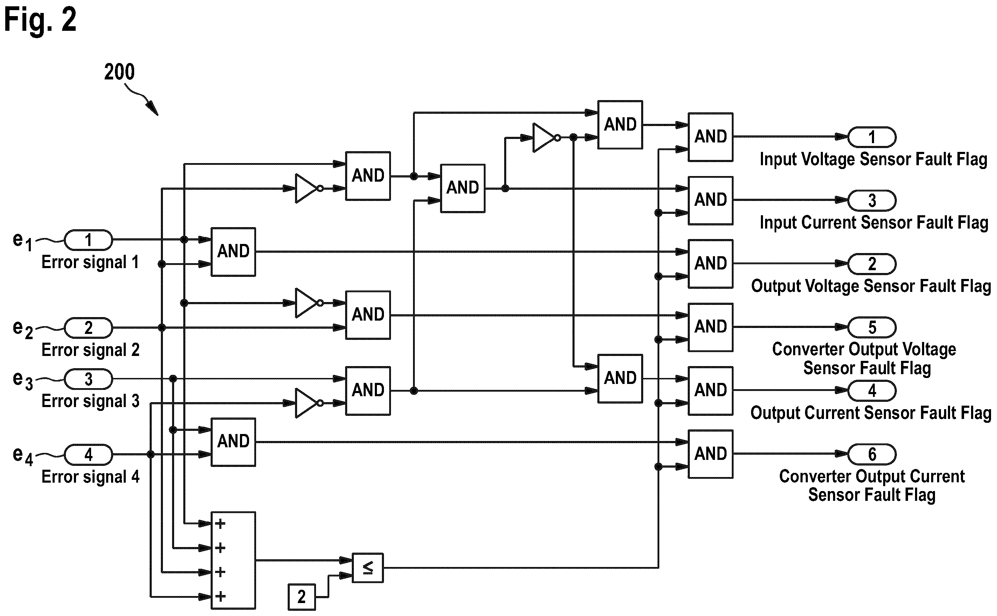

FIG. 2 shows the fault identification logic 200 according to embodiments of the present disclosure. The fault identification logic 200 may be applied to the Boolean error signals *e*₁, *e₂,e₃,e₄* (obtained from the error signals *E*₁,*E*₂*,E*₃*,E*₄ after filtering and inputting the filtered error signals to a comparator with hysteresis) to obtain an indication of a sensor fault or the indication of an absence of sensor faults.

The fault identification logic 200 implements all the described functions such that:
If *e*₁ is high and *e*₂ is high and no more than any two error signals among *e*₁*,e*₂*,e*₃*,e*₄ are high, then an output voltage *uₒᵤₜ* sensor fault is flagged.
If *e*₃ is high and *e*₄ is high and no more than any two error signals among *e*₁*,e*₂*,e*₃*,e*₄ are high, then a converter output current *i_{converterAC}* sensor fault is flagged.
If *e*₂ is high and *e*₁ is low and no more than any two error signals among *e*₁,*e*₂,*e*₃,*e*₄are high, then a converter output voltage *u_{converterAC}*sensor fault is flagged.
If *e*₁ is high and *e*₂ is low and *e*₃is high and *e*₄ is low and no more than any two error signals among *e*₁,*e*₂,*e*₃,*e*₄are high, then an input current *iᵢₙ* sensor fault is flagged.
If *e*₁ is high and *e*₂is low and *e*₃ is low and no more than any two error signals among*e*₁,*e*₂, *e*₃,*e*₄ are high, then an input voltage *uᵢₙ* sensor fault is flagged.
If *e*₃ is high and *e*₄ is low and *e*₁ is low and no more than any two error signals among *e*₁, *e*₂,*e*₃,*e*₄are high, then an output current *iₒᵤₜ* sensor fault is flagged.

Embodiments of the present disclosure improve a fault detection specifically in a ZISC based UPS system, based on the consideration of patterns of error signals obtained from the absolute values of differences between measured values and corresponding expected values, after a filtering operation and a feeding to a comparator with hysteresis.

The patterns uniquely identify faults in specific sensors, capturing the interrelationships between deviations of estimated values from measured values.

When any sensor fault is flagged, no more than any two error signals are high at the same time. Thereby false positive sensor fault flags that may otherwise occur for example during transients are prevented or reduced, according to embodiments of the present disclosure.

The fault identification logic receives as input the error signals *e*₁*,e*₂*,e*₃*,e*₄ according to embodiments of the present disclosure. The logic 200 is configured to flag an input voltage sensor fault flag, an input current sensor fault flag, an output voltage sensor fault flag, a converter output voltage sensor fault flag, an output current sensor fault flag, and a converter output current sensor fault flag according to embodiments of the present disclosure and therefore implements the previously described function(s).

It may also be convenient to flag the sensor faults with a delay, ensuring that the error signals are stable and accurately detected in order to avoid false positives.

Therefore, in some embodiments, the sensor fault flag signals are set active high after a predefined trust time.

The fault identification logic may be implemented by any suitable implementation, like for example using am integrated circuit and/or a microcontroller and/or any computing device and/or any programmable hardware like e.g. a field programmable gate array and/or any software or hardware implementation providing the described fault identification logic.

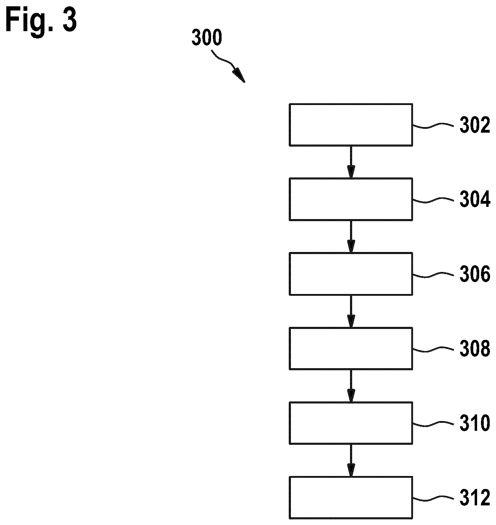

FIG. 3 illustrates a method 300 for controlling an impedance isolated single conversion topology uninterruptible power supply system according to embodiments of the present disclosure comprising current and voltage sensors, a power converter, a coupling transformer, a reactor, and having an impedance isolated single converter topology, the method comprising:
- measuring 302 a plurality of voltages and/or currents using the current and voltage sensors of the uninterruptible power supply system to obtain a plurality of measured parameters of the uninterruptible power supply;
- computing 304 one or more error signals *E*₁,*E*₂,*E*₃,*E*₄, wherein each error signal is based on a distance between a measured parameter of the uninterruptible power supply and a corresponding estimated value of the measured parameter; wherein the estimated value of the measured parameter is computed based on one or more other measured parameters in the plurality of measured parameters and/or based on a model of the uninterruptible power supply;
- filtering 306 each error signal to obtain one or more filtered error signals;
- inputting 308 each of the one or more filtered error signals to a comparator with hysteresis to obtain one or more Boolean error signals *e*₁*,e*₂*,e*₃*,e*₄
- applying 310 a fault identification logic 200 to the one or more Boolean error signals *e*₁,*e*₂, *e*₃,*e*₄ to obtain an indication of a sensor fault related to a sensor of the uninterruptible power supply system (input voltage sensor fault flag, input current sensor fault flag, output voltage sensor fault flag, converter output voltage sensor fault flag, output current sensor fault flag, converter output current sensor fault flag) or the indication of an absence of sensor faults;
- controlling 312 the uninterruptible power supply system based on the indication of the sensor fault or on the indication of the absence of sensor faults.

In particular, an (overall) indication of a sensor fault may be set to high if and only if the input voltage sensor fault flag is high and/or the input current sensor fault flag is high and/or the output voltage sensor fault flag is high and/or the converter output voltage sensor fault flag is high and/or the output current sensor fault flag is high and/or the converter output current sensor flag is high.

When a sensor fault is flagged, the control of the UPS may comprise a warning and/or a switch off of the UPS or a bypass of the UPS and/or a fault correction may be implemented based on sensors not flagged as faulty.

The warning may be used for example to replace the faulty sensor and to control the UPS based in particular on the replaced sensor.

When no sensor faults are flagged, the control of the UPS may be based on the values as measured by the current and voltage sensors.

In some embodiments, the plurality of measured parameters comprises one or more of a measured input current magnitude, a measured output current magnitude, a measured converter output current magnitude, a measured input voltage magnitude, a measured output voltage magnitude, measured converter output voltage magnitude.

The measurements are advantageous to collect enough information to properly control the UPS and also to advantageously estimate parameters based on the measured values.

In some embodiments, the one or more error signals comprise an absolute value of a difference between measured input current magnitude and an estimated value of the input current magnitude and/or an absolute value of a difference between measured converter output current magnitude and an estimated value of the converter output current magnitude and/or an absolute value of a difference between measured output voltage magnitude and a converted value of measured converter output voltage at the primary side of the coupling transformer to the secondary side of the coupling transformer and/or an absolute value of a difference between measured output current magnitude and an estimated value of the output current magnitude.

The error signals are useful to flag faults according to embodiments of the present disclosure.

In some embodiments, the plurality of measured parameters, the one or more error signals and the indication of the sensor fault are obtained in real time.

A real time flagging of faults becomes therefore possible. A real time indication may require the time necessary to evaluate the presence of faults based on e.g. the fault identification logic according to embodiments of the present disclosure.

In some embodiments, an estimated complex input current magnitude is obtained based on a quotient obtained dividing a difference between a complex input voltage and a complex output voltage by the reactor impedance; wherein an estimated value of the converter output current magnitude is obtained from the output current of all sub converter modules; wherein an estimated value of output current magnitude is obtained from the measured input current magnitude and the measured converter output current magnitude.

Estimated values can be compared with measured values.

In some embodiments, the word "magnitude" may relate to a complex number, e.g. a phasor, and the magnitude may indicate the whole phasor, i.e. the magnitude may be a complex number or alternatively a vector.

In some alternative embodiments, the magnitude may be the modulus of a complex number, e.g. the modulus of a phasor, i.e. a scalar.

Therefore, in some embodiments, the magnitude may be a real number (e.g. a modulus of a complex number) and in alternative embodiments the magnitude may be a complex number (e.g. the complex phasor).

In some embodiments applying the fault identification logic 200 to obtain an indication of a sensor fault or the indication of an absence of sensor fault comprises one or more of more of the following:
- if the Boolean error signal corresponding to the absolute value of a difference between measured input current magnitude and an estimated value of the input current magnitude AND the Boolean error signal corresponding to the absolute value of a difference between measured output voltage magnitude and an converted value of measured converter output voltage at the primary side of the coupling transformer to the secondary side of the coupling transformer ARE EACH AT HIGH STATE AND no more than any two Boolean error signals are at high state, setting the output voltage sensor fault flag high to indicate the fault in the output voltage sensor of the uninterruptible power supply system;
- if the Boolean error signal corresponding to the absolute value of a difference between measured output current magnitude and an estimated value of the output current magnitude AND the Boolean error signal corresponding to the absolute value of a difference between measured converter output current magnitude and an estimated value of the converter output current magnitude ARE EACH AT HIGH STATE AND no more than any two Boolean error signals are at high state, setting the converter output current sensor fault flag high to indicate the fault in the converter output current sensor of the uninterruptible power supply system;
- if the Boolean error signal corresponding to the absolute value of a difference between measured output voltage magnitude and a converted value of measured converter output voltage at the primary side of the coupling transformer to the secondary side of the coupling transformer AND the inverted Boolean error signal corresponding to the absolute value of a difference between measured input current magnitude and an estimated value of the input current magnitude ARE EACH AT HIGH STATE AND no more than any two Boolean error signals are at high state, setting the converter output voltage sensor fault flag high to indicate the fault in the converter output voltage sensor of the uninterruptible power supply system;
- if the Boolean error signal corresponding to the absolute value of a difference between measured input current magnitude and an estimated value of the input current magnitude AND the inverted Boolean error signal corresponding to the absolute value of a difference between measured output voltage magnitude and a converted value of measured converter output voltage at the primary side of the coupling transformer to the secondary side of the coupling transformer AND the Boolean error signal corresponding to the an absolute value of a difference between measured output current magnitude and an estimated value of the output current magnitude AND the inverted Boolean error signal corresponding to the absolute value of a difference between measured converter output current magnitude and an estimated value of the converter output current magnitude ARE EACH AT HIGH STATE AND no more than any two Boolean error signals are at high state, setting input current sensor fault flag high to indicate the fault in the input current sensor of the uninterruptible power supply system;

- if the Boolean error signal corresponding to the absolute value of a difference between measured input current magnitude and an estimated value of the input current magnitude AND the inverted Boolean error signal corresponding to the absolute value of a difference between measured output voltage magnitude and a converted value of measured converter output voltage at the primary side of the coupling transformer to the secondary side of the coupling transformer AND the inverted Boolean error signal corresponding to the absolute value of a difference between the measured output current magnitude and the sum of the measured input current magnitude and the measured converter output current magnitude ARE EACH AT HIGH STATE AND no more than any two Boolean error signals are at high state, setting input voltage sensor fault flag high to indicate the fault in the input voltage sensor of the uninterruptible power supply system;
- if the Boolean error signal corresponding to the an absolute value of a difference between measured output current magnitude and an estimated value of the output current magnitude AND the inverted Boolean error signal corresponding to the an absolute value of a difference between measured converter output current magnitude and an estimated value of the converter output current magnitude AND the inverted absolute value of a difference between measured input current magnitude and an estimated value of the input current magnitude ARE EACH AT HIGH STATE AND no more than any two Boolean error signals are at high state, setting output current sensor fault flag high to indicate the fault in the output current sensor of the uninterruptible power supply system;
wherein the indication of the sensor fault is based on the output voltage sensor fault flag, the converter output current sensor fault flag, the converter output voltage sensor fault flag, the input current sensor fault flag, the input voltage sensor fault flag, and the output current sensor fault flag.

If no sensor fault flags are set to high, i.e. if all sensor fault flags are low then an absence of sensor fault is detected.

If at least one sensor fault flag is set to high, an indication of a sensor fault is obtained.

When an indication of a sensor fault is obtained, the control of the UPS may comprise a warning and/or a switch off of the UPS or a bypass of the UPS and/or a fault correction may be implemented based on sensors not flagged as faulty.

In some embodiments, the sensor fault flag signals are set active high after a predefined trust time to ensure the flag signal is reliable.

This ensures that any transient signal does not erroneously result in flagging a sensor fault and also ensures that any error signal is stable before a sensor fault is flagged.

Embodiments of the present disclosure further provide an impedance isolated single conversion topology uninterruptible power supply system 110 comprising current 162 and voltage 160 sensors, a power converter 114, a coupling transformer 118, a reactor 116, and a system controller and having an impedance isolated single conversion topology, wherein:
- the system controller is configured to obtain a plurality of measured parameters of the uninterruptible power supply system based on measured voltages and/or currents obtained with the current and voltage sensors of the uninterruptible power supply system;
- the system controller is configured to compute one or more error signals *E*_{1,}*E*₂*,E*₃*,E*₄, wherein each error signal is based on a distance between a measured parameter of the uninterruptible power supply and a corresponding estimated value of the measured parameter; wherein the estimated value of the measured parameter is computed based on one or more other measured parameters in the plurality of measured parameters and/or based on a model of the uninterruptible power supply;
- the system controller is configured to filter each error signal to obtain one or more filtered error signals;
- the system controller is configured to implement a comparator with hysteresis to obtain one or more Boolean error signals *e*₁*,e*₂*,e*₃*,e*₄ such that each of the one or more filtered error signals is inputted to the comparator with hysteresis to obtain the one or more Boolean error signals *e*₁*,e*₂*,e*₃*,e*₄;
- the system controller is configured to apply a fault identification logic 200 to the one or more Boolean error signals *e*₁*,e*₂*,e*₃*,e*₄ to obtain an indication a sensor fault related to a sensor of the uninterruptible power supply system (input voltage sensor fault flag, input current sensor fault flag, output voltage sensor fault flag, converter output voltage sensor fault flag, output current sensor fault flag, converter output current sensor fault flag) or the indication of an absence of sensor faults;
- the system controller is configured to control the uninterruptible power supply based on the indication of the sensor fault or on the indication of the absence of sensor faults.

The impedance isolated single conversion topology uninterruptible power supply system and/or the system controller may in particular be configured to control the uninterruptible power supply system based on the methods according to embodiments of the present disclosure. Features, properties and advantages already described for methods according to embodiments of the present disclosure are therefore combinable with and extend to the systems of the present disclosure.

In particular, the system may be configured such that an (overall) indication of a sensor fault may be set to high if and only if the input voltage sensor fault flag is high and/or the input current sensor fault flag is high and/or the output voltage sensor fault flag is high and/or the converter output voltage sensor fault flag is high and/or the output current sensor fault flag is high and/or the converter output current sensor flag is high in accordance with embodiments of the present disclosure.

When a sensor fault is flagged by the fault identification logic 200, the system controller may implement a control of the UPS comprising a warning and/or a switch off of the UPS or a bypass of the UPS and/or a fault correction may be implemented based on sensors not flagged as faulty.

The system and the controller may use any suitable electronic implementation to implement the described functions and any combination of hardware and/or software based implementation may be used to provide the described functionalities. For example, dedicated integrated circuits and/or microcontrollers and/or computer systems and/or field programmable gate arrays may be used to implement the systems and functions described in embodiments of the present disclosure.

Embodiments of the present disclosure also provide a computer program product comprising instruction which, when executed by a system controller of an impedance isolated single conversion topology uninterruptible power supply system according to embodiments of the present disclosure, causes the system controller of the impedance isolated single conversion topology uninterruptible power supply system to carry out methods according to embodiments of the present disclosure.

The computer program product may for example include firmware and/or software for configuring the system controller and/or may be provided on any suitable medium and/or downloaded over a network or over the Internet to be installed and/or to configure said system controller.

## Claims

1. A method for controlling an impedance isolated single conversion topology uninterruptible power supply system comprising current and voltage sensors, a power converter, a coupling transformer, a reactor, and having an impedance isolated single converter topology, the method comprising:
- measuring a plurality of voltages and/or currents using the current and voltage sensors of the uninterruptible power supply system to obtain a plurality of measured parameters of the uninterruptible power supply;
- computing one or more error signals, wherein each error signal is based on a distance between a measured parameter of the uninterruptible power supply and a corresponding estimated value of the measured parameter; wherein the estimated value of the measured parameter is computed based on one or more other measured parameters in the plurality of measured parameters and/or based on a model of the uninterruptible power supply;
- filtering each error signal to obtain one or more filtered error signals;
- inputting each of the one or more filtered error signals to a comparator with hysteresis to obtain one or more Boolean error signals;
- applying a fault identification logic to the one or more Boolean error signals to obtain an indication of a sensor fault related to a sensor of the uninterruptible power supply system or the indication of an absence of sensor faults;
- controlling the uninterruptible power supply system based on the indication of the sensor fault or on the indication of the absence of sensor faults.

2. The method of claim 1, wherein the plurality of measured parameters comprises one or more of a measured input current magnitude, a measured output current magnitude, a measured converter output current magnitude, a measured input voltage magnitude, a measured output voltage magnitude, measured converter output voltage magnitude.

3. The method of any of claims from 1 to 2, wherein the one or more error signals comprise an absolute value of a difference between measured input current magnitude and an estimated value of the input current magnitude and/or an absolute value of a difference between measured converter output current magnitude and an estimated value of the converter output current magnitude and/or an absolute value of a difference between measured output voltage magnitude and a converted value of measured converter output voltage at the primary side of the coupling transformer to the secondary side of the coupling transformer and/or an absolute value of a difference between measured output current magnitude and an estimated value of the output current magnitude.

4. The method of any of claims from 1 to 3, wherein the plurality of measured parameters, the one or more error signals and the indication of the sensor fault are obtained in real time.

5. The method of any of claims from 1 to 4, wherein an estimated complex input current magnitude is obtained based on a quotient obtained dividing a difference between a complex input voltage and a complex output voltage by the reactor impedance; wherein an estimated value of the converter output current magnitude is obtained from the output current of all sub converter modules; wherein an estimated value of output current magnitude is obtained from the measured input current magnitude and the measured converter output current magnitude.

6. The method of any of claims from 1 to 5, wherein applying the fault identification logic to obtain an indication of a sensor fault or the indication of an absence of sensor fault comprises one or more of the following:
- if the Boolean error signal corresponding to the absolute value of a difference between measured input current magnitude and an estimated value of the input current magnitude AND the Boolean error signal corresponding to the absolute value of a difference between measured output voltage magnitude and an converted value of measured converter output voltage at the primary side of the coupling transformer to the secondary side of the coupling transformer ARE EACH AT HIGH STATE AND no more than any two Boolean error signals are at high state, setting the output voltage sensor fault flag high to indicate the fault in the output voltage sensor of the uninterruptible power supply system;
- if the Boolean error signal corresponding to the absolute value of a difference between measured output current magnitude and an estimated value of the output current magnitude AND the Boolean error signal corresponding to the absolute value of a difference between measured converter output current magnitude and an estimated value of the converter output current magnitude ARE EACH AT HIGH STATE AND no more than any two Boolean error signals are at high state, setting the converter output current sensor fault flag high to indicate the fault in the converter output current sensor of the uninterruptible power supply system;
- if the Boolean error signal corresponding to the absolute value of a difference between measured output voltage magnitude and a converted value of measured converter output voltage at the primary side of the coupling transformer to the secondary side of the coupling transformer AND the inverted Boolean error signal corresponding to the absolute value of a difference between measured input current magnitude and an estimated value of the input current magnitude ARE EACH AT HIGH STATE AND no more than any two Boolean error signals are at high state, setting the converter output voltage sensor fault flag high to indicate the fault in the converter output voltage sensor of the uninterruptible power supply system;
- if the Boolean error signal corresponding to the absolute value of a difference between measured input current magnitude and an estimated value of the input current magnitude AND the inverted Boolean error signal corresponding to the absolute value of a difference between measured output voltage magnitude and a converted value of measured converter output voltage at the primary side of the coupling transformer to the secondary side of the coupling transformer AND the Boolean error signal corresponding to the an absolute value of a difference between measured output current magnitude and an estimated value of the output current magnitude AND the inverted Boolean error signal corresponding to the absolute value of a difference between measured converter output current magnitude and an estimated value of the converter output current magnitude ARE EACH AT HIGH STATE AND no more than any two Boolean error signals are at high state, setting input current sensor fault flag high to indicate the fault in the input current sensor of the uninterruptible power supply system;
- if the Boolean error signal corresponding to the absolute value of a difference between measured input current magnitude and an estimated value of the input current magnitude AND the inverted Boolean error signal corresponding to the absolute value of a difference between measured output voltage magnitude and a converted value of measured converter output voltage at the primary side of the coupling transformer to the secondary side of the coupling transformer AND the inverted Boolean error signal corresponding to the absolute value of a difference between the measured output current magnitude and the sum of the measured input current magnitude and the measured converter output current magnitude ARE EACH AT HIGH STATE AND no more than any two Boolean error signals are at high state, setting input voltage sensor fault flag high to indicate the fault in the input voltage sensor of the uninterruptible power supply system;
- if the Boolean error signal corresponding to the an absolute value of a difference between measured output current magnitude and an estimated value of the output current magnitude AND the inverted Boolean error signal corresponding to the an absolute value of a difference between measured converter output current magnitude and an estimated value of the converter output current magnitude AND the inverted absolute value of a difference between measured input current magnitude and an estimated value of the input current magnitude ARE EACH AT HIGH STATE AND no more than any two Boolean error signals are at high state, setting output current sensor fault flag high to indicate the fault in the output current sensor of the uninterruptible power supply system;
and wherein the indication of the sensor fault is based on the output voltage sensor fault flag, the converter output current sensor fault flag, the converter output voltage sensor fault flag, the input current sensor fault flag, the input voltage sensor fault flag, and the output current sensor fault flag.

7. The method of any of claims from 1 to 6, wherein the sensor fault flag signals are set active high after a predefined trust time to ensure the flag signal is reliable.

8. An impedance isolated single conversion topology uninterruptible power supply system comprising current and voltage sensors, a power converter, a reactor, and a system controller and having an impedance isolated single conversion topology, wherein:
- the system controller is configured to obtain a plurality of measured parameters of the uninterruptible power supply system based on measured voltages and/or currents obtained with the current and voltage sensors of the uninterruptible power supply system;
- the system controller is configured to compute one or more error signals, wherein each error signal is based on a distance between a measured parameter of the uninterruptible power supply and a corresponding estimated value of the measured parameter; wherein the estimated value of the measured parameter is computed based on one or more other measured parameters in the plurality of measured parameters and/or based on a model of the uninterruptible power supply;
- the system controller is configured to filter each error signal to obtain one or more filtered error signals;
- the system controller is configured to implement a comparator with hysteresis to obtain one or more Boolean error signals such that each of the one or more filtered error signals is inputted to the comparator with hysteresis to obtain the one or more Boolean error signals;
- the system controller is configured to apply a fault identification logic to the one or more Boolean error signals to obtain an indication of a sensor fault related to a sensor of the uninterruptible power supply system or the indication of an absence of sensor faults;
- the system controller is configured to control the uninterruptible power supply based on the indication of the sensor fault or on the indication of the absence of sensor faults.

9. The impedance isolated single conversion topology uninterruptible power supply system according to claim 8, wherein the plurality of measured parameters comprises one or more of a measured input current magnitude, a measured output current magnitude, a measured converter output current magnitude, a measured input voltage magnitude, a measured output voltage magnitude, measured converter output voltage magnitude.

10. The impedance isolated single conversion topology uninterruptible power supply system according to any of claims from 8 to 9, wherein the one or more error signals comprise an absolute value of a difference between measured input current magnitude and an estimated value of the input current magnitude and/or an absolute value of a difference between measured converter output current magnitude and an estimated value of the converter output current magnitude and/or an absolute value of a difference between measured output voltage magnitude and a converted value of measured converter output voltage at the primary side of the coupling transformer to the secondary side of the coupling transformer and/or an absolute value of a difference between measured output current magnitude and an estimated value of the output current magnitude.

11. The impedance isolated single conversion topology uninterruptible power supply system according to any of claims from 8 to 10 further configured to obtain the plurality of measured parameters, the one or more error signals and the indication of the sensor fault in real time.

12. The impedance isolated single conversion topology uninterruptible power supply system according to any of claims from 8 to 11 further configured such that an estimated complex input current magnitude is obtained based on a quotient obtained dividing a difference between a complex input voltage and a complex output voltage by the reactor impedance; and further configured such that an estimated value of the converter output current magnitude is obtained from the output current of all sub converter modules; and further configured such that an estimated value of output current magnitude is obtained from the measured input current magnitude and the measured converter output current magnitude.

13. The impedance isolated single conversion topology uninterruptible power supply system according to any of claims from 8 to 12, wherein the system and the fault identification logic are configured to implement one or more of the following::
- if the Boolean error signal corresponding to the absolute value of a difference between measured input current magnitude and an estimated value of the input current magnitude AND the Boolean error signal corresponding to the absolute value of a difference between measured output voltage magnitude and an converted value of measured converter output voltage at the primary side of the coupling transformer to the secondary side of the coupling transformer ARE EACH AT HIGH STATE AND no more than any two Boolean error signals are at high state, setting the output voltage sensor fault flag high to indicate the fault in the output voltage sensor of the uninterruptible power supply system;
- if the Boolean error signal corresponding to the absolute value of a difference between measured output current magnitude and an estimated value of the output current magnitude AND the Boolean error signal corresponding to the absolute value of a difference between measured converter output current magnitude and an estimated value of the converter output current magnitude ARE EACH AT HIGH STATE AND no more than any two Boolean error signals are at high state, setting the converter output current sensor fault flag high to indicate the fault in the converter output current sensor of the uninterruptible power supply system;
- if the Boolean error signal corresponding to the absolute value of a difference between measured output voltage magnitude and a converted value of measured converter output voltage at the primary side of the coupling transformer to the secondary side of the coupling transformer AND the inverted Boolean error signal corresponding to the absolute value of a difference between measured input current magnitude and an estimated value of the input current magnitude ARE EACH AT HIGH STATE AND no more than any two Boolean error signals are at high state, setting the converter output voltage sensor fault flag high to indicate the fault in the converter output voltage sensor of the uninterruptible power supply system;
- if the Boolean error signal corresponding to the absolute value of a difference between measured input current magnitude and an estimated value of the input current magnitude AND the inverted Boolean error signal corresponding to the absolute value of a difference between measured output voltage magnitude and a converted value of measured converter output voltage at the primary side of the coupling transformer to the secondary side of the coupling transformer AND the Boolean error signal corresponding to the an absolute value of a difference between measured output current magnitude and an estimated value of the output current magnitude AND the inverted Boolean error signal corresponding to the absolute value of a difference between measured converter output current magnitude and an estimated value of the converter output current magnitude ARE EACH AT HIGH STATE AND no more than any two Boolean error signals are at high state, setting input current sensor fault flag high to indicate the fault in the input current sensor of the uninterruptible power supply system;
- if the Boolean error signal corresponding to the absolute value of a difference between measured input current magnitude and an estimated value of the input current magnitude AND the inverted Boolean error signal corresponding to the absolute value of a difference between measured output voltage magnitude and a converted value of measured converter output voltage at the primary side of the coupling transformer to the secondary side of the coupling transformer AND the inverted Boolean error signal corresponding to the absolute value of a difference between the measured output current magnitude and the sum of the measured input current magnitude and the measured converter output current magnitude ARE EACH AT HIGH STATE AND no more than any two Boolean error signals are at high state, setting input voltage sensor fault flag high to indicate the fault in the input voltage sensor of the uninterruptible power supply system;
- if the Boolean error signal corresponding to the an absolute value of a difference between measured output current magnitude and an estimated value of the output current magnitude AND the inverted Boolean error signal corresponding to the an absolute value of a difference between measured converter output current magnitude and an estimated value of the converter output current magnitude AND the inverted absolute value of a difference between measured input current magnitude and an estimated value of the input current magnitude ARE EACH AT HIGH STATE AND no more than any two Boolean error signals are at high state, setting output current sensor fault flag high to indicate the fault in the output current sensor of the uninterruptible power supply system;
and further configured such that the indication of the sensor fault is based on the output voltage sensor fault flag, the converter output current sensor fault flag, the converter output voltage sensor fault flag, the input current sensor fault flag, the input voltage sensor fault flag, and the output current sensor fault flag.

14. The impedance isolated single conversion topology uninterruptible power supply system according to any of claims from 8 to 13 further configured such that the sensor fault flag signals are set active high after a predefined trust time to ensure the flag signal is reliable.

15. A computer program product comprising instruction which, when executed by a system controller of an impedance isolated single conversion topology uninterruptible power supply system according to any of claims from 8 to 14, causes the system controller of the impedance isolated single conversion topology uninterruptible power supply system to carry out the method of any of claim from 1 to 7.
